# EUROPÄISCHE PATENTANMELDUNG

(11) **EP 4 692 842 A1**
(43) Veröffentlichungstag der Anmeldung: **11.02.2026**
(21) Anmeldenummer: 25191168.1
(22) Anmeldetag: 23.07.2025
(51) Int. Cl.: G01S 7/481, G01S 17/08

(54) **VERFAHREN ZUM FILTERN IN EINEM LASER-SYSTEM**

(30) Priorität: 07.08.2024 DE 102024207471
(71) Anmelder: Robert Bosch GmbH, 70442 Stuttgart (DE)
(72) Erfinder: Copeto, David, 71638 Ludwigsburg (DE); Noe, Stefan, 70563 Stuttgart (DE); Hoffarth, Joern, 72764 Reutlingen (DE)

(57) **Zusammenfassung**

Die Erfindung betrifft ein Verfahren (100) zum Filtern in einem Laser-System (1), umfassend die nachfolgenden Schritte:
- Definieren (101) von wenigstens zwei Konfigurationen für eine Filterung durch einen Messregler (2) des Laser-Systems (1), wobei die wenigstens zwei Konfigurationen unterschiedliche Werte für wenigstens einen Konfigurationsparameter für die Filterung angeben,
- Ermitteln (102) wenigstens einer Charakteristik eines Lasers (3) des Laser-Systems (1),
- Auswählen (103) einer jeweiligen definierten Konfiguration in Abhängigkeit von einem Ergebnis des Ermittelns (102) der wenigstens einen Charakteristik.

Ferner betrifft die Erfindung ein Computerprogramm, eine Vorrichtung sowie ein Speichermedium zu diesem Zweck.

## Beschreibung

Die Erfindung betrifft ein Verfahren zum Filtern in einem Laser-System. Ferner betrifft die Erfindung ein Computerprogramm, eine Vorrichtung sowie ein Speichermedium zu diesem Zweck.

### Stand der Technik

In modernen Laseranwendungen, die in Bereichen wie der industriellen Fertigung, der Medizintechnik, der Telekommunikation und der wissenschaftlichen Forschung weit verbreitet sind, ist eine genaue Regelung der Laserparameter entscheidend für eine Leistung und Zuverlässigkeit des Laser-Systems. Störungen und Rauschen in den Messsignalen sowie ein Schwingen des Lasers können die Regelgenauigkeit beeinträchtigen. Die Verwendung von Filtern ermöglicht die effiziente Beseitigung unerwünschter Signalanteile, wodurch die Qualität der Regelgrößen verbessert werden kann. Durch die Filterung können somit präzisere und stabilere Regelungen realisiert werden.

### Offenbarung der Erfindung

Gegenstand der Erfindung ist ein Verfahren mit den Merkmalen des Anspruchs 1, ein Computerprogramm mit den Merkmalen des Anspruchs 8, eine Vorrichtung mit den Merkmalen des Anspruchs 9 sowie ein computerlesbares Speichermedium mit den Merkmalen des Anspruchs 10. Weitere Merkmale und Details der Erfindung ergeben sich aus den jeweiligen Unteransprüchen, der Beschreibung und den Zeichnungen. Dabei gelten Merkmale und Details, die im Zusammenhang mit dem erfindungsgemäßen Verfahren beschrieben sind, selbstverständlich auch im Zusammenhang mit dem erfindungsgemäßen Computerprogramm, der erfindungsgemäßen Vorrichtung sowie dem erfindungsgemäßen computerlesbaren Speichermedium, und jeweils umgekehrt, so dass bezüglich der Offenbarung der Erfindung stets auch eine wechselseitige Bezugnahme möglich ist.

Gegenstand der Erfindung ist insbesondere ein Verfahren zum Filtern in einem Laser-System, umfassend die nachfolgenden Schritte, wobei die Schritte wiederholt und/oder nacheinander durchgeführt werden können. Das Laser-System kann beispielsweise ein Laser-Entfernungsmessgerät sein. Das Filtern kann ein analoges und/oder ein digitales Filtern sein, insbesondere ein Tiefpass-Filtern, und kann unter Verwendung eines Filters, insbesondere eines analogen oder digitalen Filters, durchgeführt werden.

In einem ersten Schritt werden vorzugsweise wenigstens zwei Konfigurationen für eine Filterung durch einen Messregler des Laser-Systems definiert, wobei die wenigstens zwei Konfigurationen unterschiedliche Werte für wenigstens einen Konfigurationsparameter für die Filterung angeben. In anderen Worten unterscheiden sich die Werte der wenigstens zwei Konfigurationen voneinander hinsichtlich des wenigstens einen Konfigurationsparameters. Bei mehreren Konfigurationsparametern kann zwischen jeweiligen Konfigurationen ein Unterschied bei wenigstens einem Konfigurationsparameter oder auch bei mehreren Konfigurationsparametern vorgesehen sein. Der wenigstens eine Konfigurationsparameter kann beispielsweise eine Filterbandbreite, ein Verstärkungsfaktor und/oder eine Regelhäufigkeit sein.

In einem weiteren Schritt wird vorzugsweise wenigstens eine Charakteristik eines Lasers des Laser-Systems ermittelt. Die wenigstens eine Charakteristik kann beispielsweise eine Stabilität des Lasers repräsentieren. Ferner kann die wenigstens eine Charakteristik eine Anzahl an Moden, eine Stromaufnahme des Laser-Systems, periodische Schwankungen in einer Ausgangsleistung (englisch: "ripple") des Laser-Systems, und/oder Speckle repräsentieren. "Speckle" bezeichnet insbesondere ein Körnungsmuster, das entsteht, wenn kohärentes Licht (wie das von einem Laser) auf eine raue Oberfläche trifft oder durch ein Medium mit Unregelmäßigkeiten streut. Die resultierende Interferenz der reflektierten oder gestreuten Lichtwellen erzeugt dabei beispielsweise ein zufälliges, fleckenartiges Muster. Die Stabilität kann beispielsweise auf Basis eines Schwingens und/oder eines Rauschens in einem Signal bestimmt werden, das für eine Laserleistung des Lasers oder eine Lichtemission des Lasers spezifisch ist. So könnten beispielsweise verschiedene Level des Schwingens und/oder des Rauschens für entsprechende Stabilitätslevel, bzw. für eine Stabilität oder Instabilität, spezifisch sein.

In einem weiteren Schritt wird vorzugsweise eine jeweilige definierte Konfiguration in Abhängigkeit von einem Ergebnis des Ermittelns der wenigstens einen Charakteristik ausgewählt und vorzugsweise ferner auch angewendet. Das Anwenden kann indizieren, dass die jeweiligen Werte der definierten Konfiguration für die Filterung verwendet werden. In anderen Worten kann ein für die Filterung verwendeter Filter entsprechend der ausgewählten Konfiguration parametriert werden. So kann vorteilhaft dynamisch auf Basis der wenigstens einen Charakteristik das Filtern mit der jeweiligen Konfiguration durchgeführt werden. Beispielsweise kann vorgesehen sein, dass bei einer geringen Stabilität, d.h. beispielsweise bei einem starken Schwingen des Lasers, ein geringes Filtern angewendet wird, also beispielsweise eine geringe Filterbandbreite, ein hoher Verstärkungsfaktor und/oder eine hohe Regelhäufigkeit, und umgekehrt im Falle einer hohen Stabilität.

Nach einer weiteren Möglichkeit kann vorgesehen sein, dass das Verfahren ferner den folgenden Schritt umfasst:
- Definieren wenigstens eines Schwellwertes hinsichtlich der wenigstens einen Charakteristik des Lasers.

Das Auswählen kann anschließend auf Basis eines Vergleiches der ermittelten wenigstens einen Charakteristik mit dem definierten wenigstens einen Schwellwert durchgeführt werden. Beispielsweise könnte hierbei eine Konfiguration für einen Bereich unter einem jeweiligen Schwellwert und eine weitere Konfiguration für einen Bereich über dem jeweiligen Schwellwert vorgesehen sein und entsprechend ausgewählt werden. Es können dabei beliebig viele Schwellwerte und entsprechende Bereiche der Konfigurationen über und unter den Schwellwerten definiert werden. So können vorteilhaft passende Konfigurationen für die verschiedenen Bereiche unter bzw. über dem wenigstens einen Schwellwert ermittelt und ausgewählt werden.

Es ist ferner denkbar, dass eine Korrelation zwischen der wenigstens einen Charakteristik und dem wenigstens einen Konfigurationsparameter definiert wird, um das Auswählen dynamisch auf Basis der definierten Korrelation durchzuführen. Dies kann beispielsweise unter Verwendung einer mathematischen Formel durchgeführt werden, die die Korrelation repräsentiert. So kann vorteilhaft das dynamische Auswählen der definierten Konfiguration noch präziser und differenzierter durchgeführt werden.

Von weiterem Vorteil kann vorgesehen sein, dass das Verfahren ferner den folgenden Schritt umfasst:
- Definieren einer Zeitspanne, in der das Auswählen nicht durchgeführt wird. Die Zeitspanne kann einer Einschwingzeit, bzw. Hysterese, des Lasers entsprechen. Diese Einschwingzeit kann dafür zuvor auf Basis von entsprechenden Messungen ermittelt werden. So kann vorteilhaft zunächst die anfängliche Einschwingzeit durch ein entsprechendes schnelles Regeln überbrückt werden, bevor das Auswählen der Konfigurationen zum Einsatz kommt. Gemäß einer weiteren Möglichkeit kann anstelle einer festen Zeitspanne ein Befehl definiert werden, der einen Wechsel der Konfigurationen, d.h. das Auswählen, erst freischaltet.

Ebenfalls Gegenstand der Erfindung ist ein Computerprogramm, insbesondere Computerprogrammprodukt, umfassend Befehle, die bei der Ausführung des Computerprogrammes durch einen Computer diesen veranlassen, das erfindungsgemäße Verfahren auszuführen. Damit bringt das erfindungsgemäße Computerprogramm die gleichen Vorteile mit sich, wie sie ausführlich mit Bezug auf ein erfindungsgemäßes Verfahren beschrieben worden sind.

Ebenfalls Gegenstand der Erfindung ist eine Vorrichtung zur Datenverarbeitung, die eingerichtet ist, das erfindungsgemäße Verfahren auszuführen. Als die Vorrichtung kann bspw. ein Computer vorgesehen sein, welcher das erfindungsgemäße Computerprogramm ausführt. Der Computer kann wenigstens einen Prozessor zur Ausführung des Computerprogramms aufweisen. Auch kann ein nicht-flüchtiger Datenspeicher vorgesehen sein, in welchem das Computerprogramm hinterlegt und von welchem das Computerprogramm durch den Prozessor zur Ausführung ausgelesen werden kann. Die Vorrichtung kann auch eine analoge diskrete elektronische Schaltung oder eine integrierte elektronische Schaltung sein, die entsprechend eingerichtet ist, das erfindungsgemäße Verfahren auszuführen.

Ebenfalls Gegenstand der Erfindung kann ein computerlesbares Speichermedium sein, welches das erfindungsgemäße Computerprogramm aufweist und/oder Befehle umfasst, die bei der Ausführung durch einen Computer diesen veranlassen, das erfindungsgemäße Verfahren auszuführen. Das Speichermedium ist bspw. als ein Datenspeicher wie eine Festplatte und/oder ein nicht-flüchtiger Speicher und/oder eine Speicherkarte ausgebildet. Das Speichermedium kann z. B. in den Computer integriert sein.

Darüber hinaus kann das erfindungsgemäße Verfahren auch als ein computerimplementiertes Verfahren ausgeführt sein. Alternativ oder zusätzlich kann zumindest einer der offenbarten Verfahrensschritte computer-implementiert sein und/oder automatisiert durchgeführt werden.

Weitere Vorteile, Merkmale und Einzelheiten der Erfindung ergeben sich aus der nachfolgenden Beschreibung, in der unter Bezugnahme auf die Zeichnungen Ausführungsbeispiele der Erfindung im Einzelnen beschrieben sind. Dabei können die in den Ansprüchen und in der Beschreibung erwähnten Merkmale jeweils einzeln für sich oder in beliebiger Kombination erfindungswesentlich sein. Es zeigen:
- Fig. 1: eine schematische Visualisierung eines Verfahrens, einer Vorrichtung, eines Speichermediums sowie eines Computerprogramms gemäß Ausführungsbeispielen der Erfindung,
- Fig. 2: eine schematische Darstellung eines Laser-Systems gemäß Ausführungsbeispielen der Erfindung.

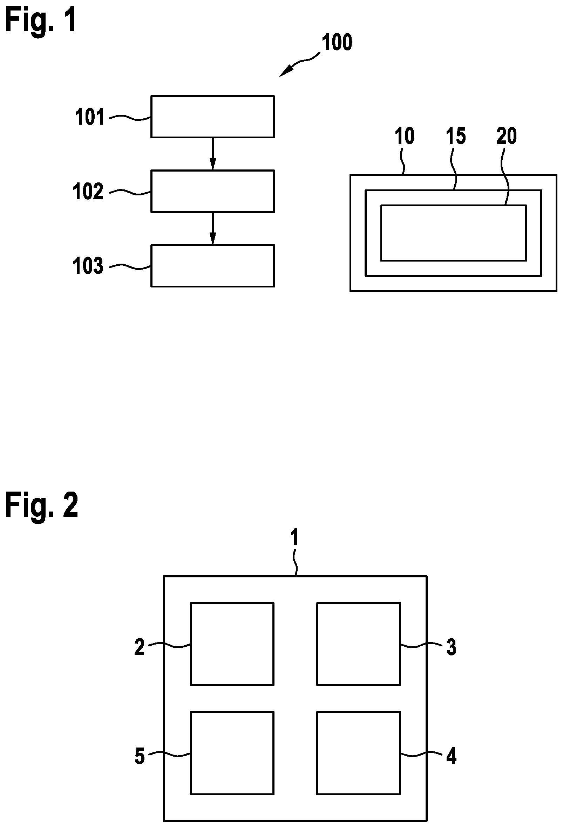

In Fig. 1 sind ein Verfahren 100, eine Vorrichtung 10, ein Speichermedium 15 sowie ein Computerprogramm 20 gemäß Ausführungsbeispielen der Erfindung schematisch dargestellt.

Fig. 1 zeigt insbesondere ein Verfahren 100 zum Filtern in einem Laser-System 1. In einem ersten Schritt 101 werden wenigstens zwei Konfigurationen für eine Filterung durch einen Messregler 2 des Laser-Systems 1 definiert, wobei die wenigstens zwei Konfigurationen unterschiedliche Werte für wenigstens einen Konfigurationsparameter für die Filterung angeben. In einem zweiten Schritt 102 wird wenigstens eine Charakteristik eines Lasers 3 des Laser-Systems 1 ermittelt. In einem dritten Schritt 103 wird eine jeweilige definierte Konfiguration in Abhängigkeit von einem Ergebnis des Ermittelns 102 der wenigstens einen Charakteristik ausgewählt.

Das Verfahren der vorliegenden Erfindung betrifft ein Laser-System 1 und gemäß Ausführungsbeispielen insbesondere ein Laser-Entfernungsmessgerät, das die indirekte Time of Flight (iToF)-Messung verwendet. Für dieses Ausführungsbeispiel sei auf Fig. 2 verwiesen. Dieses Laser-Entfernungsmessgerät 1 arbeitet beispielsweise mit einer Messung einer Phasenverschiebung eines modulierten Lichtsignals, das vom Laser-Entfernungsmessgerät ausgesendet und von einem Zielobjekt reflektiert wird. Im Folgenden wird die Funktionsweise der indirekten Time of Flight (iToF)-Messung beschrieben. Zunächst kann ein Laser 3 im Laser-Entfernungsmessgerät 1 intensitätsmoduliertes Licht, beispielsweise im infraroten oder sichtbaren Bereich, in Richtung eines Zielobjekts senden. Die Modulation erfolgt insbesondere mit einer sinusförmigen oder Rechteckwelle. Das intensitätsmodulierte Licht trifft anschließend auf das Zielobjekt und wird zurück zum Laser-Entfernungsmessgerät 1 reflektiert. Ein Detektor 4 im Messgerät kann nun das reflektierte Licht empfangen. Da das Licht eine gewisse Zeit benötigt, um die Strecke hin und zurück zu legen, kommt es zu einer Phasenverschiebung zwischen dem ausgesendeten und dem empfangenen Signal. Diese Phasenverschiebung zwischen dem ausgesendeten und dem empfangenen Signal kann anschließend gemessen werden. Diese Phasenverschiebung ist insbesondere proportional zur zurückgelegten Entfernung des Lichts. Die Entfernung kann anschließend aus der Phasenverschiebung unter Berücksichtigung der Wellenlänge der Modulation und der Lichtgeschwindigkeit berechnet werden. Hierbei kann ferner vorgesehen sein, dass eine Referenzphase mit einem zweiten Detektor mit einem konstanten Abstand bestimmt wird (nicht dargestellt), um die Phasenverschiebung auf Basis eines Vergleiches mit der Referenzphase zu bestimmen.

Das Laser-Entfernungsmessgerät 1 kann einen Messregler 2 aufweisen. Der Messregler 2 übernimmt insbesondere eine Steuerung des Lasers 3.

So kann der Messregler 2 eine Emission des Lasers 3 steuern, indem er ein Ein- und Ausschalten sowie eine Intensität eines Laserstrahls des Lasers 3 regelt. Dadurch kann sichergestellt werden, dass der Laserstrahl mit der richtigen Leistung und den richtigen Eigenschaften ausgesendet wird.

Ferner kann ein Laserstrahl des Laser-Systems 1 moduliert werden, beispielsweise in Form von gepulstem Licht und/oder einer kontinuierlichen Welle mit variabler Modulationsfrequenz. Nach dem Empfang zumindest eines Bruchteils des ausgesendeten Laserstrahls durch den Detektor 4 (beispielsweise eine Photodiode) kann der Messregler 2 das empfangene Signal verarbeiten kann der Messregler 2 das empfangene Signal verarbeiten. Dies umfasst beispielsweise eine Verstärkung, Filterung und Umwandlung des empfangenen analogen Signals, d.h. insbesondere das Intensitätssignal des Lasers, in ein digitales Signal zur weiteren Analyse, insbesondere durch einen Analog-Digital-Wandler 5. Ferner kann die Phasenverschiebung zwischen dem ausgesendeten und dem empfangenen Signal messen und gegebenenfalls mit der Referenzphase verglichen werden.

Der Messregler 2 kann ferner regelmäßig Kalibrierungen durchführen, um sicherzustellen, dass die Messungen präzise sind. Dafür kann er einen Zustand des Lasers 3 und des Detektors 4 überwachen, um sicherzustellen, dass diese ordnungsgemäß funktionieren.

Zudem kann das Laser-System 1, insbesondere das Laser-Entfernungsmessgerät, einen Analog-Digital-Wandler 5 aufweisen. Der Analog-Digital-Wandler 5 wandelt vorzugsweise analoge Signale, die vom Detektor 4 empfangen werden, in digitale Signale um. Diese Signale repräsentieren insbesondere eine Lichtintensität, die vom Laser 3 ausgesendet wird. Die digitale Umwandlung kann es ermöglichen, die Phasenverschiebung zwischen dem ausgesendeten und dem empfangenen Signal zu analysieren. Die digitalen Signale, die vom Analog-Digital-Wandler 5 bereitgestellt werden, können weiter gefiltert, verstärkt und verarbeitet werden, um Rauschen zu reduzieren und die Signalqualität zu verbessern.

Durch die zwei Sätze an Konfigurationen kann der Messregler 2 bei einem Erreichen eines definierten Schwellwerts umschalten. Werden in einer langsamen, präzisen Regelung gemäß einer ersten Konfiguration Störungen zu groß, wechselt der Messregler 2 vorzugsweise ab einem weiteren Schwellwert wieder zurück in eine schnelle unpräzise Regelung gemäß einer zweiten Konfiguration. Die Konfigurationen umfassen beispielsweise eine Filterbandbreite, einen Verstärkungsfaktor und/oder eine Regelhäufigkeit.

Die voranstehende Erläuterung der Ausführungsformen beschreibt die vorliegende Erfindung ausschließlich im Rahmen von Beispielen. Selbstverständlich können einzelne Merkmale der Ausführungsformen, sofern technisch sinnvoll, frei miteinander kombiniert werden, ohne den Rahmen der vorliegenden Erfindung zu verlassen.

## Patentansprüche

1. Verfahren (100) zum Filtern in einem Laser-System (1), umfassend die nachfolgenden Schritte:
- Definieren (101) von wenigstens zwei Konfigurationen für eine Filterung durch einen Messregler (2) des Laser-Systems (1), wobei die wenigstens zwei Konfigurationen unterschiedliche Werte für wenigstens einen Konfigurationsparameter für die Filterung angeben,
- Ermitteln (102) wenigstens einer Charakteristik eines Lasers (3) des Laser-Systems (1),
- Auswählen (103) einer jeweiligen definierten Konfiguration in Abhängigkeit von einem Ergebnis des Ermittelns (102) der wenigstens einen Charakteristik.

2. Verfahren (100) nach Anspruch 1,
**dadurch gekennzeichnet,**
**dass** der wenigstens eine Konfigurationsparameter eine Filterbandbreite, ein Verstärkungsfaktor und/oder eine Regelhäufigkeit ist.

3. Verfahren (100) nach einem der vorhergehenden Ansprüche,
**dadurch gekennzeichnet,**
**dass** die wenigstens eine Charakteristik eine Stabilität des Lasers (3), eine Anzahl an Moden, eine Stromaufnahme des Laser-Systems (1), periodische Schwankungen in einer Ausgangsleistung des Laser-Systems (1), und/oder Speckle repräsentiert.

4. Verfahren (100) nach einem der vorhergehenden Ansprüche,
**dadurch gekennzeichnet,**
**dass** das Verfahren (100) ferner den folgenden Schritt umfasst:
- Definieren wenigstens eines Schwellwertes hinsichtlich der wenigstens einen Charakteristik des Lasers (3),
wobei das Auswählen (103) auf Basis eines Vergleiches der ermittelten wenigstens einen Charakteristik mit dem definierten wenigstens einen Schwellwert durchgeführt wird.

5. Verfahren (100) nach einem der Ansprüche 1 bis 3,
**dadurch gekennzeichnet,**
**dass** eine Korrelation zwischen der wenigstens einen Charakteristik und dem wenigstens einen Konfigurationsparameter definiert wird, um das Auswählen (103) dynamisch auf Basis der definierten Korrelation durchzuführen.

6. Verfahren (100) nach einem der vorhergehenden Ansprüche,
**dadurch gekennzeichnet,**
**dass** das Verfahren (100) ferner den folgenden Schritt umfasst:
- Definieren einer Zeitspanne, in der das Auswählen (103) nicht durchgeführt wird.

7. Verfahren (100) nach einem der vorhergehenden Ansprüche,
**dadurch gekennzeichnet,**
**dass** das Laser-System (1) ein Laser-Entfernungsmessgerät ist.

8. Computerprogramm (20), umfassend Befehle, die bei der Ausführung des Computerprogramms (20) durch einen Computer (10) diesen veranlassen, das Verfahren (100) nach einem der vorhergehenden Ansprüche auszuführen.

9. Vorrichtung (10) zur Datenverarbeitung, die eingerichtet ist, das Verfahren (100) nach einem der Ansprüche 1 bis 7 auszuführen.

10. Computerlesbares Speichermedium (15), umfassend Befehle, die bei der Ausführung durch einen Computer (10) diesen veranlassen, die Schritte des Verfahrens (100) nach einem der Ansprüche 1 bis 7 auszuführen.
